# EUROPEAN PATENT APPLICATION

(11) **EP 4 391 093 A1**
(43) Date of publication of application: **26.06.2024**
(21) Application number: 21957594.1
(22) Date of filing: 14.09.2021
(51) Int. Cl.: H01L 33/44, H01L 33/22, H01L 33/48, H01L 33/40, H01L 33/62, H01L 27/15

(54) **SEMICONDUCTOR LIGHT EMITTING ELEMENT AND DISPLAY DEVICE**

(71) Applicant: LG Electronics Inc., Yeongdeungpo-gu Seoul 07336 (KR)
(72) Inventor: LEE, Jaehyuk, Seoul 06772 (KR); PARK, Chilkeun, Seoul 06772 (KR); CHO, Byoungkwon, Seoul 06772 (KR); PARK, Sungmin, Seoul 06772 (KR)
(74) Representative: Vossius & Partner Patentanwälte Rechtsanwälte mbB
(86) International application number: PCT/KR2021/012487
(87) International publication number: WO 2023/042926

(57) **Abstract**

The semiconductor light emitting device may include a light emitting unit, a first electrode on the bottom and side of the light emitting unit, and a second electrode on the top of the light emitting unit, a plurality of trenches on the sides of the light emitting unit, and a passivation layer on a side of the light emitting unit, and an end of the passivation layer may be located in one of the plurality of trenches.

## Description

### [Technical Field]

The embodiment relates to a semiconductor light emitting device and a display device.

### [Background Art]

Display devices display high-definition images using self-luminous elements such as light emitting diodes as light sources for pixels. Light emitting diodes exhibit excellent durability even under harsh environmental conditions and are capable of long lifespan and high brightness, so they are attracting attention as a light source for next-generation display devices.

Recently, research is underway to manufacture ultra-small light emitting diodes using highly reliable inorganic crystal structure materials and place them on panels of display devices (hereinafter referred to as "display panels") to use them as next-generation light sources.

These display devices are expanding beyond flat displays into various forms such as flexible displays, foldable displays, stretchable displays, and rollable displays.

In order to implement high resolution, the size of pixels is gradually becoming smaller, and light emitting devices are to be aligned in numerous pixels of such smaller sizes, so that research on the manufacture of ultra-small light emitting diodes as small as micro or nano scale is being actively conducted.

Display devices typically contain tens of millions of pixels or more. Accordingly, because it is very difficult to align at least one light emitting device in each of tens of millions of small pixels, various studies on ways to align light emitting devices in a display panel are being actively conducted.

As the size of light emitting devices becomes smaller, quickly and accurately transferring these light emitting devices onto a substrate has become a very important problem to solve. Transfer technologies that have been recently developed include the pick and place process, laser lift-off method, or self-assembly method. In particular, a self-assembly method that transfers a light emitting device onto a substrate using a magnetic material (or magnet) has recently been in the spotlight.

In the self-assembly method, numerous light emitting devices are dropped into a bath containing a fluid, and as the magnetic material moves, the light emitting devices dropped into the fluid are moved to the pixels of the substrate, and the light emitting devices are aligned at each pixel. Therefore, the self-assembly method is attracting attention as a next-generation transfer method because it may quickly and accurately transfer numerous light emitting devices onto a substrate.

Meanwhile, light emitting devices assembled on a substrate by self-assembly method are electrically connected by heat compression method. That is, the bonding layer provided on the lower part of the light emitting device is melted by thermal compression and is electrically connected to the electrical wiring of the substrate.

However, there are the following problems when thermally compressing the bonding layer of a conventional light emitting device.

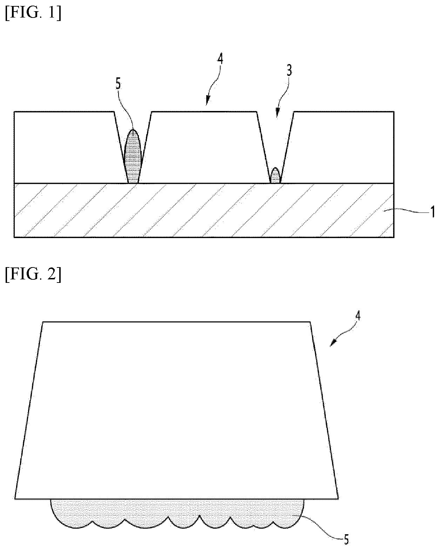

FIG. 1 shows the bonding material escaping around the light emitting device.

As shown in FIG. 1, when the light emitting device 4 is assembled into the assembly hole 3 and then heat-compressed, the bonding material 5 on the lower side of the light emitting device 4 is between the light emitting device 4 and the substrate 1. Rather than staying there, it escapes around the light emitting device 4. In this way, the bonding material 5 escapes around the light emitting device 4 and some of the bonding material 5 forms a sharp spire as high as the light emitting device 4. When electrode wiring (not shown) is placed on the upper side of the light emitting device 4 by a post-process, a problem occurs in which the upper and lower portions of the light emitting device 5 are electrically shorted due to the electrode wiring being in electrical contact with the bonding material 5.

FIG. 2 is a cross-sectional view showing a conventional light emitting device.

As shown in FIG. 2, a bonding material 5 is provided on the lower side of a conventional light emitting device. Conventionally, there is no structure provided to prevent the bonding material 5 from escaping in the side direction during heat compression.

Therefore, when the conventional light emitting device shown in FIG. 2 is thermo-compressed on the substrate 1 using a thermo-compression method as shown in FIG. 1, the bonding material 5 melted by the heat generated during the thermal compression process does not stay on the lower side of the light emitting device 4 but escapes to the surroundings of the light emitting device 4.

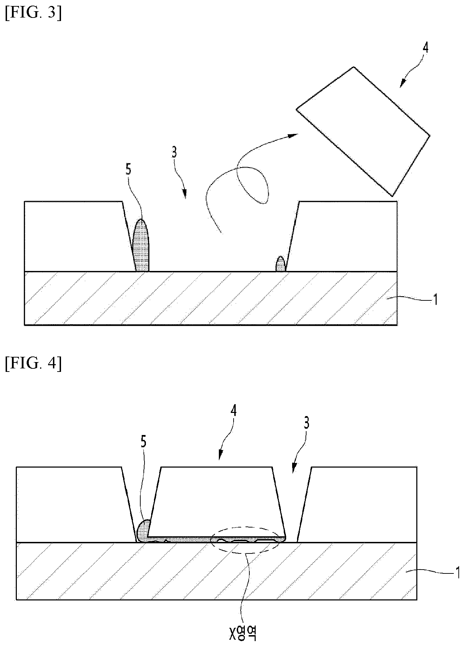

FIG. 3 shows the light emitting device being separated.

If the bonding material 5 previously escaped around the light emitting device 4, there was almost no bonding material 5 between the light emitting device 4 and the substrate 1, as shown in FIG. 3, the light emitting device 4 is not attached to the substrate 1 and is separated. That is, the light emitting device 5 is attached to the substrate 1 by the bonding material 5. In order for the light emitting device 5 to be strongly attached to the substrate 1, a certain bonding material 5 is to be exist under the light emitting device 5 despite heat compression. However, during heat compression, most of the bonding material 5 provided on the lower side of the light emitting device 5 escapes around the light emitting device 5 and only a small amount of the bonding material 5 remains on the lower side of the light emitting device 5. Accordingly, the light emitting device 5 is not strongly attached to the substrate 1, and there is a problem that the light emitting device 5 is easily separated from the substrate 1. Deviation of the light emitting device 5 reduces the assembly rate and causes assembly defects or lighting defects.

FIG. 4 shows a poor electrical connection between the light emitting device and the electrical wiring of the substrate.

As shown in FIG. 4, when the bonding material 5 escapes to the periphery of the light emitting device 4 due to thermal compression, there is almost no bonding material 5 remaining on the lower side of the light emitting device 4 (see area That is, since the bonding material 5 does not exist continuously between the light emitting device 4 and the substrate 1 but exists locally, the electrical connection between the light emitting device 4 and the substrate 1 is also locally connected. This leads to an increase in electrical resistance between the light emitting device 4 and the substrate 1, which causes the electrical signal from the substrate 1 to not be easily supplied to the light emitting device 4, resulting in a decrease in luminance.

### [Disclosure]

### [Technical Problem]

The embodiment aims to solve the above-mentioned problems and other problems.

Another object of the embodiment is to provide a semiconductor light emitting device in which the formation position of the passivation layer may be freely adjusted.

Another object of the embodiment is to provide a semiconductor light emitting device that may easily form a first electrode on the side of the light emitting portion.

Another object of the embodiment is to provide a display device capable of achieving high brightness by including a semiconductor light emitting device with improved light extraction efficiency.

Another object of the embodiment is to provide a display device that may prevent bonding defects.

Another object of the embodiment is to provide a display device that may strengthen bonding force.

Another object of the embodiment is to provide a display device that may prevent assembly defects and lighting defects.

The technical objects of the embodiments are not limited to those described in this item and include those that may be understood through the description of the invention.

### [Technical Solution]

According to one aspect of the embodiment to achieve the above or other purposes, the semiconductor light emitting device includes a light emitting unit; a first electrode on the bottom and sides of the light emitting unit; a second electrode on the top of the light emitting unit; a plurality of trenches on the side of the light emitting portion; and a passivation layer on the side of the light emitting unit, wherein an end of the passivation layer may be located in one of the plurality of trenches.

The plurality of trenches may be arranged along the circumference of the side portion of the light emitting unit.

The end of the first electrode may be located in the one trench.

The end of the first electrode may contact the end of the passivation layer in the one trench.

The end of the first electrode may be located on the passivation layer.

Each of the plurality of trenches may have an asymmetric groove.

According to another aspect of the embodiment, the display device may include a substrate; first and second assembly wirings on the substrate; a partition wall disposed on the a first assembly wiring and a second assembly wiring and having an assembly hole; a semiconductor light emitting device in the assembly hole; and a connection electrode disposed in the assembly hole and connecting the semiconductor light emitting device to at least one of the first and second assembly wirings, the semiconductor light emitting device includes a light emitting unit; a first electrode on the bottom and sides of the light emitting unit; a second electrode on the top of the light emitting unit; a plurality of trenches on the side of the light emitting portion; and a passivation layer on the side of the light emitting unit, wherein an end of the passivation layer is disposed in one of the plurality of trenches.

The connection electrode may be disposed along the circumference of the semiconductor light emitting device within the assembly hole.

The display device includes an insulating layer on the partition wall; and an electrode wiring connected to the semiconductor light emitting device through the insulating layer.

### [Advantageous Effects]

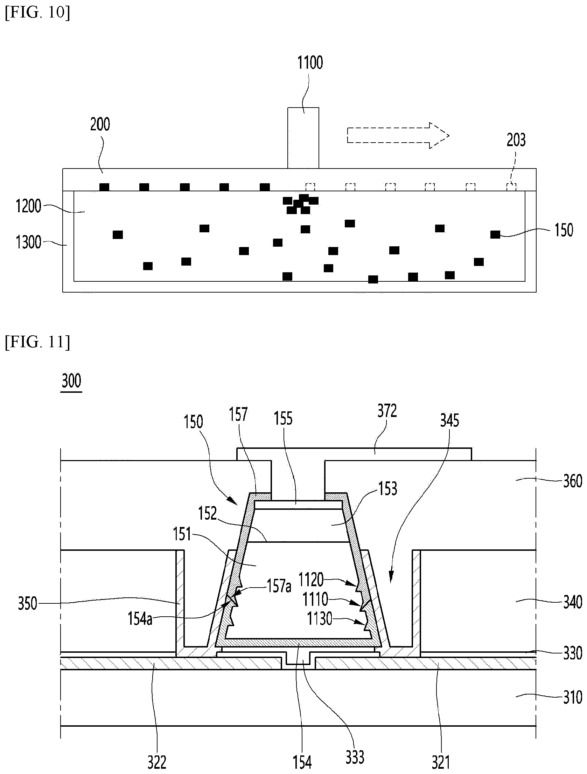

In the embodiment, as shown in FIG. 11, trenches 1110, 1120, and 1130 that determine the formation position of the passivation layer 157 are disposed on the side of the semiconductor light emitting device 150, by placing the first electrode 154 at a certain height on the side of the semiconductor light emitting device 150, in the display device 300, image quality may be improved by preventing image quality unevenness between sub-pixels on the substrate 310.

In the embodiment, the semiconductor light emitting device 150 may be connected to at least one of the first assembly wiring 321 and the second assembly wiring 322 using the connection electrode 350. That is, the first electrode 154 is disposed along the side perimeter of the light emitting portions 151, 152, and 153 of the semiconductor light emitting device 150, and the connection electrode 350 may be in contact with the first electrode 154. Accordingly, the connection electrode 350 is connected to the first electrode 154 along the side perimeter of the light emitting portions 151, 152, and 153 of the semiconductor light emitting device 150, the contact area between the connection electrode 350 and the semiconductor light emitting device 150 is maximized to obtain maximum brightness.

In addition, since the connection electrode 350 is disposed of a uniform size in the assembly hole 345 of each of the plurality of sub-pixels defined on the substrate 310, since the contact area between the connection electrode 350 and the semiconductor light emitting device 150 is the same, image quality may be improved by obtaining uniform luminance between the plurality of sub-pixels.

Additionally, since the semiconductor light emitting device 150 of each pixel is stably electrically connected to the connection electrode 350, lighting defects may be prevented.

In addition, the connection electrode 350 is disposed between the outer side of the semiconductor light emitting device 150 and the inner side of the assembly hole 345, the semiconductor light emitting device 150 may be firmly attached to the substrate 310 and/or the partition wall 340 by the connection electrode 350 to prevent the semiconductor light emitting device 150 from being separated.

In addition, since the connection electrode 350 is formed only within the assembly hole 345, electrical short circuit between the connection electrode 350 and the electrode wiring 372 formed by a post-process may be prevented.

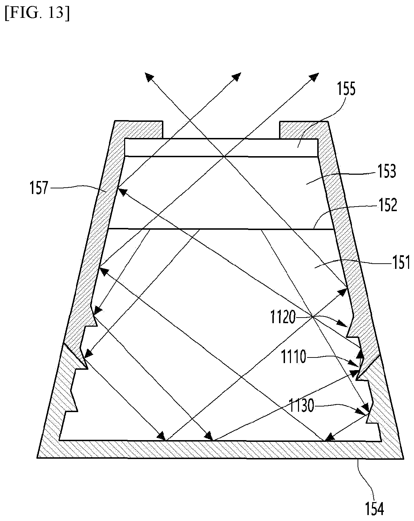

Meanwhile, in the embodiment, as shown in FIG. 13, the light generated in the active layer 152 is reflected or scattered by a plurality of trenches to extract more light, brightness may be improved by improving light extraction efficiency.

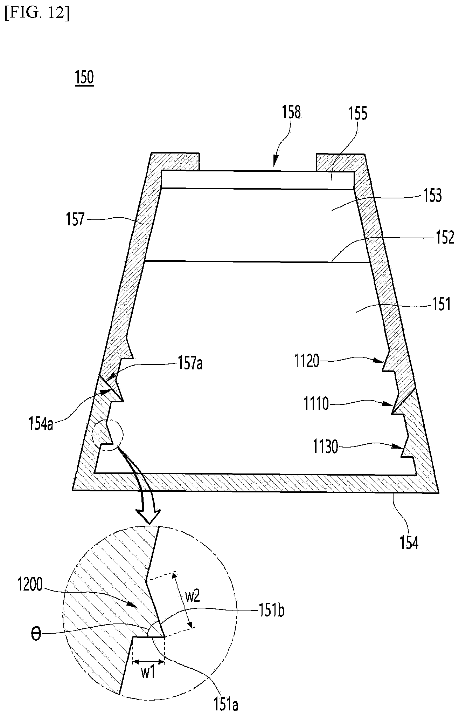

Additionally, as shown in FIG. 12, a plurality of trenches 1110, 1120, and 1130 are disposed on the side of the semiconductor light emitting device 150, and by disposing the first electrode 154 and the passivation layer 157 in the trenches 1110, 1120, and 1130, the contact area between each of the first electrode 154 and the passivation layer 157 and the side of the semiconductor light emitting device 150 is increased, thereby preventing the first electrode 154 and the passivation layer 157 from being separated.

In addition, as shown in FIG. 11, the connection electrode 350 is in contact with the outer side of the semiconductor light emitting device 150, at least one of the first and second assembly wirings 321 and 322, and the inner side of the assembly hole 345, reliability may be strengthened by strengthening the fixation of the semiconductor steel element 150.

Additional scope of applicability of the embodiments will become apparent from the detailed description below. However, since various changes and modifications within the spirit and scope of the embodiments may be clearly understood by those skilled in the art, the detailed description and specific embodiments, such as preferred embodiments, is to be understood as being given by way of example only.

### [Description of Drawings]

FIG. 1 shows the bonding material escaping around the light emitting device.
FIG. 2 is a cross-sectional view showing a conventional light emitting device.
FIG. 3 shows the light emitting element being separated.
FIG. 4 shows a poor electrical connection between the light emitting device and the electrical wiring of the substrate.
FIG. 5 shows a living room of a house where a display device according to an embodiment is placed.
FIG. 6 is a block diagram schematically showing a display device according to an embodiment.
FIG. 7 is a circuit diagram showing an example of the pixel of FIG. 6.
FIG. 8 is an enlarged view of the first panel area in the display device of FIG. 5.
FIG. 9 is an enlarged view of area A2 in FIG. 8.
FIG. 10 is a diagram showing an example in which a light emitting device according to an embodiment is assembled on a substrate by a self-assembly method.
FIG. 11 is a cross-sectional view showing a display device according to an embodiment.
FIG. 12 is a cross-sectional view showing a semiconductor light emitting device according to the first embodiment.
FIG. 13 shows the path of light in the semiconductor light emitting device according to the first embodiment.
FIG. 14 shows the lighting distribution of a display device equipped with a conventional light emitting element electrically connected through a bonding method.
FIG. 15 shows the lighting distribution of a display device equipped with a semiconductor light emitting device electrically connected through a deposition method in an embodiment.
FIGS. 16 to 29 show the manufacturing process of a semiconductor light emitting device according to the first embodiment.
FIG. 30 is a cross-sectional view showing a semiconductor light emitting device according to the second embodiment.

The size, shape, and dimensions of the components shown in the drawings may differ from the actual ones. In addition, although the same components are shown in different sizes, shapes, and numbers between drawings, this is only an example in the drawings, identical components may have the same size, shape, and numerical value between drawings.

### [Mode for Invention]

Hereinafter, embodiments disclosed in the present specification will be described in detail with reference to the attached drawings, but identical or similar components will be assigned the same reference numbers regardless of the reference numerals, and duplicate descriptions thereof will be omitted. The suffixes 'module' and 'part' for components used in the following description are given or used interchangeably in consideration of ease of specification preparation, and do not have distinct meanings or roles in themselves. Additionally, the attached drawings are intended to facilitate easy understanding of the embodiments disclosed in this specification, and the technical idea disclosed in this specification is not limited by the attached drawings. Additionally, when an element such as a layer, region or substrate is referred to as being 'on' another component, this includes either directly on the other element or there may be other intermediate elements in between.

Display devices described in this specification include TVs, shines, mobile phones, smart phones, head-up displays (HUDs) for automobiles, backlight units for laptop computers, displays for VR or AR, etc. However, the configuration according to the embodiment described in this specification may be applied to a device capable of displaying even if it is a new product type that is developed in the future.

Hereinafter, a light emitting device according to an embodiment and a display device including the same will be described.

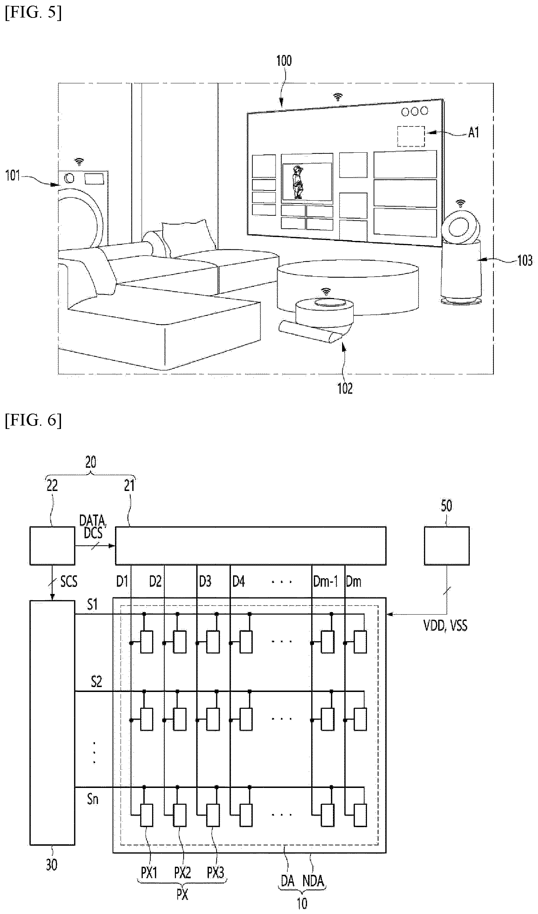

FIG. 5 shows a living room of a house where a display device according to an embodiment is placed.

Referring to FIG. 5, the display device 100 of the embodiment may display the status of various electronic products such as a washing machine 101, a robot vacuum cleaner 102, and an air purifier 103, may communicate with each electronic product based on IOT and may also control each electronic product based on the user's setting data.

The display device 100 according to the embodiment may include a flexible display manufactured on a thin and flexible substrate. Flexible displays may bend or curl like paper while maintaining the characteristics of existing flat displays.

In a flexible display, visual information may be implemented by independently controlling the light emission of unit pixels arranged in a matrix form. A unit pixel refers to the minimum unit for implementing one color. A unit pixel of a flexible display may be implemented by a light emitting device. In the embodiment, the light emitting device may be Micro-LED or Nano-LED, but is not limited thereto.

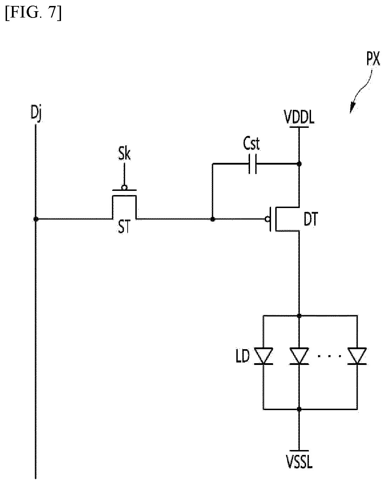

FIG. 6 is a block diagram schematically showing a display device according to an embodiment, and FIG. 7 is a circuit diagram showing an example of the pixel of FIG. 6.

Referring to FIGS. 6 and 7, a display device according to an embodiment may include a display panel 10, a driving circuit 20, a scan driver 30, and a power supply circuit 50.

The display device 100 of the embodiment may drive the light emitting device in an active matrix (AM, Active Matrix) method or a passive matrix (PM, Passive Matrix) method.

The driving circuit 20 may include a data driver 21 and a timing control unit 22.

The display panel 10 may be rectangular, but this is not limited. That is, the display panel 10 may be formed in a circular or oval shape. At least one side of the display panel 10 may be bent to a predetermined curvature.

The display panel 10 may be divided into a display area DA and a non-display area NDA disposed around the display area DA. The display area DA is an area where pixels PX are formed to display an image. The display panel 10 may include data lines (D 1 to Dm, m is an integer greater than 2), scan lines (S 1 to Sn, n is an integer greater than 2) that intersect the data lines D1 to Dm, pixels PX connected to a high-potential voltage line to which a high-potential voltage is supplied, a low-potential voltage line to which a low-potential voltage is supplied, and data lines D1 to Dm and scan lines (S1 to Sn).

Each of the pixels PX may include a first sub-pixel PX1, a second sub-pixel PX2, and a third sub-pixel PX3. The first sub-pixel PX1 emits a first color light of a first main wavelength, the second sub-pixel PX2 may emit a second color light of a second main wavelength, and the third sub-pixel PX3 may emit a third color light of a third main wavelength. The first color light may be red light, the second color light may be green light, and the third color light may be blue light, but are not limited thereto. Additionally, in FIG. 6, it is illustrated that each pixel PX includes three sub-pixels, but the present invention is not limited thereto. That is, each pixel PX may include four or more sub-pixels.

Each of the first sub-pixel PX1, the second sub-pixel PX2, and the third sub-pixel PX3 may be connected to at least one of the data lines D1 to Dm and at least one of the scan lines S1 to Sn and a high potential voltage line. As shown in FIG. 7, the first sub-pixel PX1 may include light emitting devices LD, a plurality of transistors for supplying current to the light emitting devices LD, and at least one capacitor Cst.

Although not shown in the drawing, each of the first sub-pixel PX1, the second sub-pixel PX2, and the third sub-pixel PX3 may include only one light emitting device LD and at least one capacitor Cst.

Each of the light emitting devices LD may be a semiconductor light emitting diode including a first electrode, a plurality of conductivity-type semiconductor layers, and a second electrode. Here, the first electrode may be an anode electrode and the second electrode may be a cathode electrode, but this is not limited.

The light emitting device LD may be one of a horizontal light emitting device, a flip chip type light emitting device, and a vertical light emitting device.

As shown in FIG. 7, the plurality of transistors may include a driving transistor DT that supplies current to the light emitting devices LD and a scan transistor ST that supplies a data voltage to the gate electrode of the driving transistor DT. The driving transistor DT may include a gate electrode connected to the source electrode of the scan transistor ST, a source electrode connected to a high-potential voltage line to which a high-potential voltage is applied and a drain electrode connected to the first electrodes of the light emitting devices (LD). The scan transistor ST may include a gate electrode connected to a scan line (Sk, k is an integer satisfying 1≤k≤n), a source electrode connected to the gate electrode of the driving transistor DT and a drain electrode connected to the data line (Dj, j is an integer satisfying 1≤j≤m).

The capacitor Cst is formed between the gate electrode and the source electrode of the driving transistor DT. The storage capacitor Cst charges the difference between the gate voltage and source voltage of the driving transistor DT.

The driving transistor DT and the scan transistor ST may be formed of a thin film transistor. In addition, in FIG. 7, the driving transistor DT and the scan transistor ST are explained with a focus on being formed of a P-type MOSFET (Metal Oxide Semiconductor Field Effect Transistor), but the present invention is not limited thereto. The driving transistor DT and scan transistor ST may be formed of an N-type MOSFET. In this case, the positions of the source and drain electrodes of the driving transistor DT and the scan transistor ST may be changed.

In addition, in FIG. 7, it is illustrated that each of the first sub-pixel PX1, the second sub-pixel PX2, and the third sub-pixel PX3 includes 2T1C (2 Transistor - 1 capacitor) with one driving transistor DT, one scan transistor ST, and one capacitor Cst the present invention is not limited to this. Each of the first sub-pixel PX1, the second sub-pixel PX2, and the third sub-pixel PX3 may include a plurality of scan transistors ST and a plurality of capacitors Cst.

Since the second sub-pixel PX2 and the third sub-pixel PX3 may be represented by substantially the same circuit diagram as the first sub-pixel PX1, detailed descriptions thereof will be omitted.

The driving circuit 20 outputs signals and voltages for driving the display panel 10. For this purpose, the driving circuit 20 may include a data driver 21 and a timing controller 22.

The data driver 21 receives digital video data (DATA) and source control signal DCS from the timing control unit 22. The data driver 21 converts digital video data (DATA) into analog data voltages according to the source control signal (DCS) and supplies them to the data lines (D1 to Dm) of the display panel 10.

The timing control unit 22 receives digital video data (DATA) and timing signals from the host system. Timing signals may include a vertical sync signal, a horizontal sync signal, a data enable signal, and a dot clock. The host system may be an application processor in a smartphone or tablet PC, a monitor, or a system-on-chip in a TV

The timing control unit 22 generates control signals to control the operation timing of the data driver 21 and the scan driver 30. The control signals may include a source control signal (DCS) for controlling the operation timing of the data driver 21 and a scan control signal (SCS) for controlling the operation timing of the scan driver 30.

The driving circuit 20 may be disposed in the non-display area (NDA) provided on one side of the display panel 10. The driving circuit 20 may be formed as an integrated circuit (IC) and mounted on the display panel 10 using a chip on glass (COG) method, a chip on plastic (COP) method, or an ultrasonic bonding method, but the present invention is not limited to this. For example, the driving circuit 20 may be mounted on a circuit board (not shown) rather than on the display panel 10.

The data driver 21 is mounted on the display panel 10 using a COG (chip on glass) method, a COP (chip on plastic) method, or an ultrasonic bonding method, and timing control unit 22 may be mounted on a circuit board.

The scan driver 30 receives a scan control signal (SCS) from the timing control unit 22. The scan driver 30 generates scan signals according to the scan control signal SCS and supplies them to the scan lines S1 to Sn of the display panel 10. The scan driver 30 may include a plurality of transistors and may be formed in the non-display area NDA of the display panel 10. Alternatively, the scan driver 30 may be formed as an integrated circuit, and in this case, it may be mounted on a gate flexible film attached to the other side of the display panel 10.

The circuit board may be attached to pads provided at one edge of the display panel 10 using an anisotropic conductive film. Because of this, the lead lines of the circuit board may be electrically connected to the pads. The circuit board may be a flexible printed circuit board, a printed circuit board, or a flexible film such as a chip on film. The circuit board may be bent toward the bottom of the display panel 10. Because of this, one side of the circuit board is attached to one edge of the display panel 10, and the other side is placed below the display panel 10 and may be connected to a system board on which the host system is mounted.

The power supply circuit 50 may generate voltages necessary for driving the display panel 10 from the main power supplied from the system board and supply them to the display panel 10. For example, the power supply circuit 50 generates a high potential voltage (VDD) and a low potential voltage (VSS) to drive the light emitting devices (LD) of the display panel 10 from the main power supply, so that may supply the high-potential voltage line and the low-potential voltage line of the display panel 10. Additionally, the power supply circuit 50 may generate and supply driving voltages for driving the driving circuit 20 and the scan driver 30 from the main power supply.

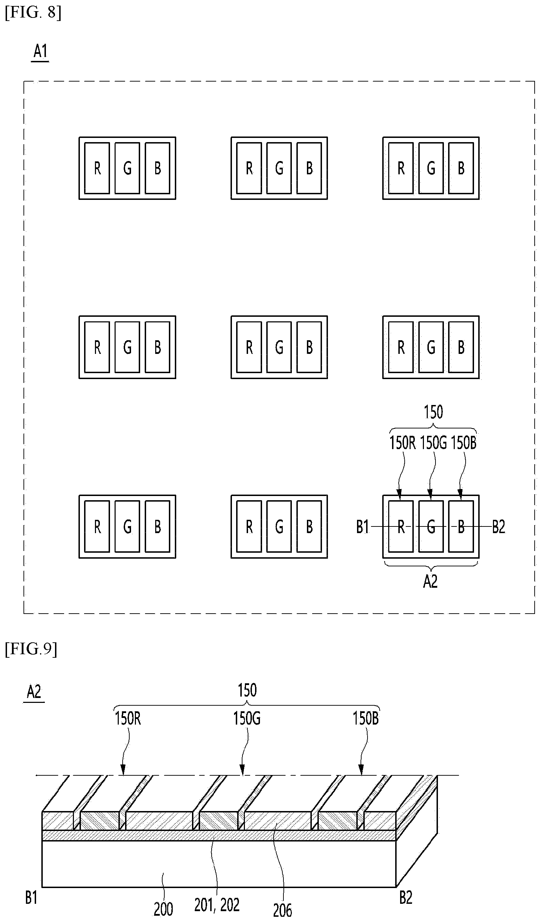

FIG. 8 is an enlarged view of the first panel area in the display device of FIG. 3.

Referring to FIG. 8, the display device 100 of the embodiment may be manufactured by mechanically and electrically connecting a plurality of panel areas, such as the first panel area A1, by tiling.

The first panel area A1 may include a plurality of light emitting devices 150 arranged for each unit pixel (PX in FIG. 6).

For example, the unit pixel PX may include a first sub-pixel PX1, a second sub-pixel PX2, and a third sub-pixel PX3. For example, a plurality of red light emitting devices 150R are disposed in the first sub-pixel PX1, a plurality of green light emitting devices 150G may be disposed in the second sub-pixel PX2, and a plurality of blue light emitting devices 150B may be disposed in the third sub-pixel PX3. The unit pixel PX may further include a fourth sub-pixel in which no light emitting device is disposed, but is not limited to this.

FIG. 9 is an enlarged view of area A2 in FIG. 8.

Referring to FIG. 9, the display device 100 of the embodiment may include a substrate 200, assembly wiring 201 and 202, an insulating layer 206, and a plurality of light emitting devices 150. More components may be included than this.

The assembly wiring may include a first assembly wiring 201 and a second assembly wiring 202 that are spaced apart from each other. The first assembly wiring 201 and the second assembly wiring 202 may be provided to generate dielectrophoretic force to assemble the light emitting device 150. For example, the light emitting device 150 may be one of a horizontal light emitting device, a flip chip type light emitting device, and a vertical light emitting device.

The light emitting device 150 may include, but is not limited to, a red light emitting device 150, a green light emitting device 150G, and a blue light emitting device 150B0 to form a unit pixel (sub-pixel) and also possible to implement red and green colors by using red phosphors and green phosphors, respectively.

The substrate 200 may be a support member that supports components placed on the substrate 200 or a protection member that protects the components.

The substrate 200 may be a rigid substrate or a flexible substrate. The substrate 200 may be made of sapphire, glass, silicon, or polyimide. Additionally, the substrate 200 may include a flexible material such as PEN (Polyethylene Naphthalate) or PET (Polyethylene Terephthalate). Additionally, the substrate 200 may be made of a transparent material, but is not limited thereto.

The substrate 200 is a backplane equipped with circuits in the sub-pixels (PX1, PX2, PX3) shown in FIGS. 4 and 5, such as transistors (ST, DT), capacitors Cst, signal wires, etc., but is not limited to this.

The insulating layer 206 may include an insulating and flexible organic material such as polyimide, PAC, PEN, PET, polymer, etc., or an inorganic material such as silicon oxide (SiO2) or silicon nitride series (SiNx), and may be integrated with the substrate 200 to form one substrate.

The insulating layer 206 may be a conductive adhesive layer that has adhesiveness and conductivity, and the conductive adhesive layer may be flexible and enable a flexible function of the display device. For example, the insulating layer 206 may be an anisotropic conductive film (ACF) or a conductive adhesive layer such as an anisotropic conductive medium or a solution containing conductive particles. The conductive adhesive layer may be a layer that is electrically conductive in a direction perpendicular to the thickness, but electrically insulating in a direction horizontal to the thickness.

The insulating layer 206 may include an assembly hole 203 into which the light emitting device 150 is inserted. Therefore, during self-assembly, the light emitting device 150 may be easily inserted into the assembly hole 203 of the insulating layer 206. The assembly hole 203 may be called an insertion hole, a fixing hole, an alignment hole, etc.

The assembly hole 203 may be different depending on the shape of the light emitting device 150. For example, the red light emitting device, the green light emitting device, and the blue light emitting device each have a different shape, and may have an assembly hole 203 having a shape corresponding to the shape of each of these light emitting devices. For example, the assembly hole 203 may include a first assembly hole for assembling the red light emitting device, a second assembly hole for assembling the green light emitting device, and a third assembly hole for assembling the blue light emitting device. For example, the red light emitting device may have a circular shape, the green light emitting device may have a first oval shape with a first minor axis and a second major axis, and the blue light emitting device may have a second oval shape with a second minor axis and a second major axis, but is not limited to this. The second major axis of the oval shape of the blue light emitting device may be larger than the second major axis of the oval shape of the green light emitting device, and the second minor axis of the oval shape of the blue light emitting device may be smaller than the first minor axis of the oval shape of the green light emitting device.

FIG. 10 is a diagram showing an example in which a light emitting device according to an embodiment is assembled on a substrate by a self-assembly method.

The self-assembly method of the light emitting device will be described with reference to FIGS. 9 and 10.

The substrate 200 may be a panel substrate of a display device. In the following description, the substrate 200 will be described as a panel substrate of a display device, but the embodiment is not limited thereto.

The substrate 200 may be formed of glass or polyimide. Additionally, the substrate 200 may include a flexible material such as PEN (Polyethylene Naphthalate) or PET (Polyethylene Terephthalate). Additionally, the substrate 200 may be made of a transparent material, but is not limited thereto.

Referring to FIG. 10, the light emitting device 150 may be inserted into the chamber 1300 filled with the fluid 1200. The fluid 1200 may be water such as ultrapure water, but is not limited thereto. The chamber may be called a water tank, container, vessel, etc.

After this, the substrate 200 may be placed on the chamber 1300. Depending on the embodiment, the substrate 200 may be input into the chamber 1300.

As shown in FIG. 9, a pair of assembly wirings 201 and 202 corresponding to each of the light emitting devices 150 to be assembled may be disposed on the substrate 200.

The assembly wirings 201 and 202 may be formed of transparent electrodes (ITO) or may contain a metal material with excellent electrical conductivity. For example, the assembly wirings 201 and 202 may be formed of at least one of titanium (Ti), chromium (Cr), nickel (Ni), aluminum (Al), platinum (Pt), gold (Au), tungsten (W), molybdenum (Mo), or an alloy thereof.

An electric field is formed in the assembly wiring (201, 202) by an externally supplied voltage, and a dielectrophoretic force may be formed between the assembly wiring (201, 202) by this electric field. The light emitting device 150 may be fixed to the assembly hole 203 on the substrate 200 by this dielectrophoretic force.

The gap between the assembly wirings 201 and 202 is formed to be smaller than the width of the light emitting device 150 and the width of the assembly hole 203, so that the assembly position of the light emitting device 150 using an electric field may be fixed more precisely.

An insulating layer 206 is formed on the assembly wirings 201 and 202 to protect the assembly wirings 201 and 202 from the fluid 1200 and prevent leakage of current flowing through the assembly wirings 201 and 202. The insulating layer 206 may be formed as a single layer or multilayer of an inorganic insulator such as silica or alumina or an organic insulator.

Additionally, the insulating layer 206 may include an insulating and flexible material such as polyimide, PEN, PET, etc., and may be integrated with the substrate 200 to form one substrate.

The insulating layer 206 may be an adhesive insulating layer or a conductive adhesive layer with conductivity. The insulating layer 206 is flexible and may enable flexible functions of the display device.

The insulating layer 206 has a partition wall, and the assembly hole 203 may be formed by this partition wall. For example, when forming the substrate 200, a portion of the insulating layer 206 is removed, so that each of the light emitting devices 150 may be assembled into the assembly hole 203 of the insulating layer 206.

An assembly hole 203 in which the light emitting devices 150 are coupled is formed in the substrate 200, and the surface where the assembly hole 203 is formed may be in contact with the fluid 1200. The assembly hole 203 may guide the exact assembly position of the light emitting device 150.

Meanwhile, the assembly hole 203 may have a shape and size corresponding to the shape of the light emitting device 150 to be assembled at the corresponding location. Accordingly, it is possible to prevent another light emitting device from being assembled in the assembly hole 203 or a plurality of light emitting devices from being assembled.

Referring again to FIG. 10, after the substrate 200 is disposed, the assembly device 1100 including a magnetic material may move along the substrate 200. For example, a magnet or electromagnet may be used as a magnetic material. The assembly device 1100 may move while in contact with the substrate 200 in order to maximize the area to which the magnetic field is applied within the fluid 1200. Depending on the embodiment, the assembly device 1100 may include a plurality of magnetic materials or a magnetic material of a size corresponding to that of the substrate 200. In this case, the moving distance of the assembly device 1100 may be limited to within a predetermined range.

By the magnetic field generated by the assembly device 1100, the light emitting device 150 in the chamber 1300 may move toward the assembly device 1100.

While moving toward the assembly device 1100, the light emitting device 150 may enter the assembly hole 203 and come into contact with the substrate 200.

At this time, by the electric field applied by the assembly wiring 201 and 202 formed on the substrate 200, the light emitting device 150 in contact with the substrate 200 may be prevented from being separated by movement of the assembly device 1100.

That is, by the self-assembly method using the electromagnetic field described above, since the time required to assemble each of the light emitting devices 150 on the substrate 200 may be drastically shortened, a large-area, high-pixel display may be implemented more quickly and economically.

A predetermined solder layer (not shown) is further formed between the light emitting device 150 assembled on the assembly hole 203 of the substrate 200 and the substrate 200, so that the bonding strength of the light emitting device 150 may be improved.

Afterwards, electrode wiring (not shown) is connected to the light emitting device 150 and power may be applied.

Next, although not shown, at least one insulating layer may be formed through a post-process. At least one insulating layer may be transparent resin or resin containing a reflective material or a scattering material.

Meanwhile, the embodiment arranges a trench that may determine the formation position of the passivation layer on the side of the semiconductor light emitting device, and the end of the passivation layer is disposed in this trench, a first electrode of a certain height may be disposed on a side of the semiconductor light emitting device. Therefore, image quality may be improved by ensuring uniform luminance between each of the plurality of sub-pixels by ensuring that the connection electrode contacts the first electrode of the semiconductor light emitting device disposed in the assembly hole of each of the plurality of sub-pixels with a uniform area. In addition, the embodiment may have various technical advantages, and these various technical advantages are described in detail below.

Descriptions omitted below may be easily understood from FIGS. 5 to 10 and the description given above in relation to the corresponding drawings.

FIG. 11 is a cross-sectional view showing a display device according to an embodiment.

Referring to FIG. 11, the display device 300 according to the embodiment may include a substrate 310, first assembly wiring 321, second assembly wiring 322, partition wall 340, semiconductor light emitting device 150, and connection electrode 350. The display device 300 according to the first embodiment may include more components than these.

Since each of the substrate 310 and the partition wall 340 is the same as the substrate 200 and the insulating layer 206 shown in FIG. 9, detailed descriptions are omitted.

The partition wall 340 may be disposed on the substrate 310. For example, the partition wall 340 may be disposed on the first assembly wiring 321 and the second assembly wiring 322. The partition wall 340 may be referred to as an insulating layer. The partition wall 340 may have a plurality of assembly holes 345. The assembly hole 345 may be provided in a sub-pixel of a pixel, but this is not limited. The assembly hole 345 guides and fixes the assembly of the semiconductor light emitting device 150, during self-assembly, the semiconductor light emitting device 150, which is moved by a magnetic material, may be moved from near the assembly hole 345 into the assembly hole 345 and fixed in the assembly hole 345.

Although the assembly hole 345 is shown in the drawing as having an inclined inner side, it may also have an inner side that is perpendicular to the upper surface of the substrate 310. The semiconductor foot and device may be easily inserted into the assembly hole 345 by the assembly hole 345 having an inclined inner side.

The first assembly wiring 321 and the second assembly wiring 322 may be disposed on the substrate 310. The first assembly wiring 321 and the second assembly wiring 322 may be provided to generate dielectrophoretic force to assemble the light emitting device 150.

Since each of the first and second assembly wirings 321 and 322 is the same as the electrode wirings 201 and 202 shown in FIG. 9, detailed descriptions are omitted.

Meanwhile, the first insulating layer 330 may be disposed on the substrate 310. First and second assembly wirings 321 and 322 may be disposed between the first insulating layer 330 and the substrate 310. The first assembly wiring 321 and the second assembly wiring 322 may be disposed on the same layer, for example, the substrate 310. That is, the first assembly wiring 321 and the second assembly wiring 322 may be in contact with the upper surface of the substrate 310. The first assembly wiring 321 and the second assembly wiring 322 may be spaced apart from each other to prevent electrical short circuit. An alternating voltage may be applied to the first assembly wiring 321 and the second assembly wiring 322, so that a dielectrophoretic force may be formed between the first assembly wiring 321 and the second assembly wiring 322. The semiconductor light emitting device 150 located in the assembly hole 345 may be fixed by this dielectrophoretic force. Since the first assembly wiring 321 and the second assembly wiring 322 are arranged horizontally side by side on the same layer, the dielectrophoretic force formed between the first assembly wiring 321 and the second assembly wiring 322 is uniform, so that the semiconductor light emitting device 150 may be positioned at the center of the assembly hole 345.

The first insulating layer 330 protects the first assembly wiring 321 and the second assembly wiring 322 from fluid (1200 in FIG. 9), and may prevent leakage current flowing through the first assembly wiring 321 and the second assembly wiring 322.

The first insulating layer 330 may increase dielectrophoretic force. For example, the first insulating layer 330 may be a dielectric layer. The first insulating layer 330 may be formed of a material with a high dielectric constant. The dielectrophoretic force may be proportional to the dielectric constant of the first insulating layer 330. Accordingly, the dielectrophoretic force formed between the first assembly wiring 321 and the second assembly wiring 322 is increased by the first insulating layer 330 made of a material with a high dielectric constant, due to this increased dielectrophoretic force, the semiconductor light emitting device 150 located in the assembly hole 345 may be fixed more firmly.

For example, the first insulating layer 330 may be formed as a single layer or multilayer of an inorganic material such as silica or alumina or an organic material.

For example, the first insulating layer 330 may include an insulating and flexible material such as polyimide, PEN, PET, etc. For example, the first insulating layer 330 may be integrated with the substrate 310 to form one substrate. That is, the first assembly wiring 321 and the second assembly wiring 322 may be embedded in the substrate 310.

The first insulating layer 330 may be an adhesive insulating layer or a conductive adhesive layer with conductivity. When the first insulating layer 330 is a conductive adhesive layer, the first assembly wiring 321 and the second assembly wiring 322 are surrounded by an insulating layer to prevent an electrical short circuit between each of the first assembly wiring 321 and the second assembly wiring 322 and the conductive adhesive layer. For example, the first insulating layer 330 is flexible and may enable a flexible function of the display device 300.

The semiconductor light emitting device 150 may be disposed in each of the plurality of assembly holes 345 provided on the substrate 310.

The semiconductor light emitting device 150 may be formed of a semiconductor material, for example, a group IV compound or a group III-V compound. The semiconductor light emitting device 150 is a member that generates light according to electrical signals.

As an example, the semiconductor light emitting device 150 disposed in each assembly hole 345 may generate single color light. For example, the semiconductor light emitting device 150 may generate ultraviolet light, purple light, blue light, etc. In this case, the semiconductor light emitting device 150 disposed in each assembly hole 345 serves as a light source, and images may be displayed by generating light of various colors using this light source. A color conversion layer and a color filter may be provided to generate light of various colors.

As another example, the semiconductor light emitting device 150 disposed in each assembly hole 345 may be one of a blue semiconductor light emitting device, a green semiconductor light emitting device, and a red semiconductor light emitting device. For example, when three assembly holes 345 are arranged side by side, the semiconductor light emitting device 150 disposed in the first assembly hole 345 may be a blue semiconductor light emitting device, the semiconductor light emitting device 150 disposed in the second assembly hole 345 may be a green semiconductor light emitting device, and the semiconductor light emitting device 150 disposed in the third assembly hole 345 may be a red semiconductor light emitting device.

The connection electrode 350 may be placed in the assembly hole 345. The connection electrode 350 may be called a connection part, a connection member, a connection metal, etc.

The connection electrode 350 may connect the semiconductor light emitting device 150 to at least one assembly wiring of the first and second assembly wirings 321 and 322. The connection electrode 350 may be made of a metal with excellent electrical conductivity. The connection electrode 350 may be made of at least one or more layers. For example, the connection electrode 350 may be made of three layers of molybdenum/aluminum/molybdenum (Mo/Al/Mo), but this is not limited.

For example, the connection electrode 350 may be disposed along the perimeter of the side of the semiconductor light emitting device 150 within the assembly hole 345. For example, the connection electrode 350 may be electrically connected to the side of the semiconductor light emitting device 150 along the circumference of the side of the semiconductor light emitting device 150 within the assembly hole 345.

As shown in FIGS. 1 to 4, during thermal compression using a bonding method, the bonding material 5 provided at the bottom of the light emitting device 4 is attached to the substrate 1 by pressure.

However, the bonding material 5 on the lower side of the light emitting device 4 escapes around the light emitting device 4 rather than staying between the light emitting device 4 and the substrate 1. The bonding material 5 that escapes to the surroundings causes an electrical short circuit with the electrode wiring formed in a later process FIG. 1. In addition, the light emitting element 4 is not firmly attached to the substrate 1, so the light emitting element 4 is separated FIG. 3. In addition, the bonding material 5 on the lower side of the light emitting device 4 escapes around the light emitting device 4 rather than remaining, since the amount of bonding material 5 remaining between the light emitting device and the substrate is small, the electrical contact area between the electrode wiring of the light emitting device 4 and the substrate 1 is small, resulting in a decrease in luminance due to an increase in contact resistance FIG. 4.

The first embodiment is intended to solve this problem and may have the following technical advantages.

According to the first embodiment, the connection electrode 350 is disposed between the outer side of the semiconductor light emitting device 150 and the inner side of the assembly hole 345, the semiconductor light emitting device 150 is firmly attached to the substrate 310 and/or the partition wall 340 by the connection electrode 350, thereby preventing the semiconductor light emitting device 150 from being separated.

According to the first embodiment, since the connection electrode 350 is formed only within the assembly hole 345, electrical short circuit between the connection electrode 350 and the electrode wiring 372 formed by a post-process may be prevented.

According to the first embodiment, the connection electrode 350 is electrically connected to the side of the semiconductor light emitting device 150 along the circumference of the side of the semiconductor light emitting device 150, the contact area between the connection electrode 350 and the semiconductor light emitting device 150 is maximized, so that maximum brightness may be obtained.

According to the first embodiment, the connection electrode 350 is disposed with a uniform size in the assembly hole 345 of each of the plurality of sub-pixels defined on the substrate 310, since the contact area between the connection electrode 350 and the semiconductor light emitting device 150 is the same, image quality may be improved by ensuring uniform luminance between the plurality of sub-pixels.

According to the first embodiment, the semiconductor light emitting device 150 of each pixel is stably electrically connected to the connection electrode 350, so lighting defects may be prevented.

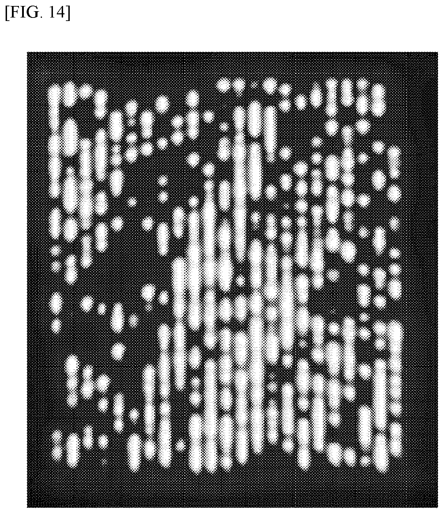

As shown in FIG. 14, when the light emitting element 4 is attached to the substrate 1 by thermal compression using the conventional bonding method (FIGS. 1, 3, and 4), it may be seen that the lighting rate decreases because the light emitting element 4 of each of the plurality of sub-pixels is turned on or not turned on.

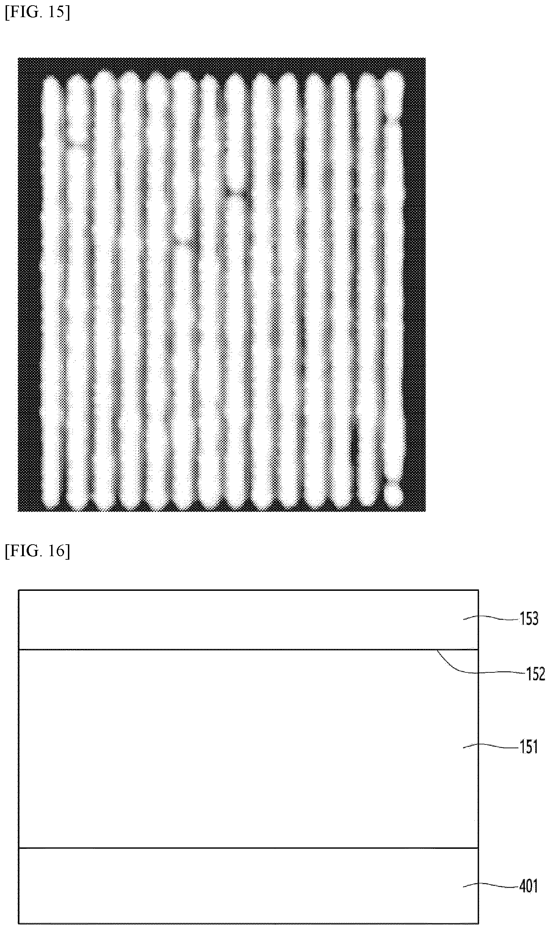

As shown in FIG. 15, when the semiconductor light emitting device 150 is attached to the substrate 310 by the deposition method according to the first embodiment, it may be seen that the semiconductor light emitting devices 150 of the plurality of sub-pixels are turned on, and the lighting rate is significantly improved.

Meanwhile, the semiconductor light emitting device 150 may be disposed in the assembly hole 345. The semiconductor light emitting device 150 according to the embodiment may have a plurality of trenches 1110, 1120, and 1130 disposed on its side. One trench among the plurality of trenches, for example, the first trench 1110, may determine the formation position of the passivation layer 157. That is, the end of the passivation layer 157 may be located in the first trench 1110.

### [First embodiment]

FIG. 12 is a cross-sectional view showing a semiconductor light emitting device according to the first embodiment.

Referring to FIG. 12, the semiconductor light emitting device 150 according to the first embodiment may include light emitting units 151, 152, and 153, a first electrode 154, a second electrode 155, trench 1110, 1120, 1130 and passivation layer 157. The semiconductor light emitting device 150 according to the first embodiment may include more components than these. The passivation layer 157 may be called an insulating layer, a protective layer, etc.

The light emitting unit may include a first conductivity-type semiconductor layer 151, an active layer 152, and a second conductivity-type semiconductor layer 153. That is, the active layer 152 may be disposed on the first conductivity-type semiconductor layer 151, and the second conductivity-type semiconductor layer 153 may be disposed on the active layer 152.

The first conductivity-type semiconductor layer 151, the active layer 152, and the second conductivity-type semiconductor layer 153 may be sequentially grown on a wafer (401 in FIG. 16) using deposition equipment such as MOCVD. Thereafter, the second conductivity-type semiconductor layer 153, the active layer 152, and the first conductivity-type semiconductor layer 151 may be etched along the vertical direction in that order using an etching process. Afterwards, the remaining area excluding a portion of the side of the first conductivity-type semiconductor layer 151, that is, the passivation layer 157 is formed along the other part of the side of the first conductivity-type semiconductor layer 151, the side of the active layer 152, and the side surface of the second conductivity-type semiconductor layer 153, a semiconductor light emitting device 150 may be manufactured.

The first conductivity-type semiconductor layer 151 may include a first conductivity type dopant, and the second conductivity-type semiconductor layer 153 may include a second conductivity type dopant. For example, the first conductivity type dopant may be an n-type dopant such as silicon (Si), and the second conductivity type dopant may be a p-type dopant such as boron (B).

For example, the first conductivity-type semiconductor layer 151 may be a place to generate electrons, and the second conductivity-type semiconductor layer 153 may be a place to form holes. The active layer 152 is a place that generates light and may be called a light emitting layer.

The first electrode 154 may be disposed on the lower portion of the light emitting units 151, 152, and 153. The first electrode 154 may be disposed on the sides of the light emitting units 151, 152, and 153. The second electrode 155 may be disposed on top of the light emitting units 151, 152, and 153. The first electrode 154 and the second electrode 155 supply current to the light emitting units 151, 152, and 153, so that the light emitting units 151, 152, and 153 may emit light with a luminance corresponding to the current.

The first electrode 154 and the second electrode 155 may be made of metal with excellent electrical conductivity. The first electrode 154 and the second electrode 155 may be made of at least one or more layers. The first electrode 154 and the second electrode 155 may be made of different metals, but are not limited thereto.

For example, at least one of the first electrode 154 and the second electrode 155 may include a magnetic layer. For example, as shown in FIG. 10, when magnetized by the magnetic material of the assembly device 1100, the semiconductor light emitting device 150 including a magnetic layer may be moved toward the magnetic material of the assembly device 1100 by applying an attractive force to the magnetic material. Accordingly, the semiconductor light emitting device 150 may be moved along the movement direction of the magnetic material of the assembly device 1100. In this way, the moving semiconductor light emitting device 150 may be pulled by the dielectrophoresis force formed in the assembly hole 345 on the substrate 310 and assembled in the assembly hole 345.

Meanwhile, the first electrode 154 may include a reflective layer. In this case, light generated in the active layer 152 is reflected, thereby improving light extraction efficiency and improving luminance.

The passivation layer 157 may be disposed on the sides of the light emitting units 151, 152, and 153. The passivation layer 157 may be disposed on top of the light emitting units 151, 152, and 153. For example, the passivation layer 157 may be disposed on the second electrode 155 of the light emitting units 151, 152, and 153.

For example, the passivation layer 157 may protect the light emitting units 151, 152, and 153.

For example, the passivation layer 157 may block leakage current of the light emitting units 151, 152, and 153. Leakage current may flow through the side of the light emitting unit 151, 152 and 153, that is, the side of the first conductivity-type semiconductor layer 151, the side of the active layer 152, and the side of the second conductivity-type semiconductor layer 153. By forming the passivation layer 157 on the side of the first conductivity-type semiconductor layer 151, the side of the active layer 152, and the side of the second conductivity-type semiconductor layer 153, leakage current may be prevented.

For example, the passivation layer 157 may help assemble the semiconductor light emitting device 150. That is, by adjusting the placement area of the first electrode 154 and the passivation layer 157 disposed on the outer side of the semiconductor light emitting device 150, the semiconductor light emitting device 150 may be pulled into the assembly hole 345 by a dielectrophoretic force formed between the first assembly wiring 321 and the second assembly wiring 322. For example, the first electrode 154 of the semiconductor light emitting device 150 is disposed close to the first assembly wiring 321 and the second assembly wiring 322, as the passivation layer 157 is disposed far from the first assembly wiring 321 and the second assembly wiring 322, the semiconductor light emitting device 150 may be pulled into the assembly hole 345 by dielectrophoresis force. Accordingly, the semiconductor light emitting device 150 may be pulled into the assembly hole 345 by the dielectrophoretic force and then continuously fixed within the assembly hole 345. Afterwards, even if dielectrophoresis force is not generated, the semiconductor light emitting device 150 may be fixed in the assembly hole 345 by natural forces such as surface tension or van der Waals force.

For example, an opening 158 without a passivation layer 157 may be formed in a portion of the second electrode 155 of the light emitting units 151, 152, and 153. As will be described later, the electrode wiring 372 may be electrically connected to the second electrode 155 of the semiconductor light emitting device 150 through the opening 158.

Meanwhile, the passivation layer 157 may be formed on a portion of the side of the light emitting portions 151, 152, and 153. That is, the passivation layer 157 is disposed in one area on the side of the light emitting units 151, 152, and 153, and the first electrode 154 may be placed in another area on the side of the light emitting units 151, 152, and 153.

The first electrode 154 is formed on the sides of the light emitting units 151, 152, and 153 in order to easily electrically connect it to the connection electrode 350. As the first electrode 154 is formed to have a larger area on the sides of the light emitting units 151, 152, and 153, the contact area between the connection electrode 350 and the first electrode 154 may be larger. In this case, current flows more smoothly through the light emitting units 151, 152, and 153 to output more light, which means that luminance is improved.

Since the first electrode 154 is formed after the passivation layer 157 is formed, the passivation layer 157 is to be formed limited to one area on the side of the light emitting portions 151, 152, and 153, it is easy to form the first electrode 154 limited to other areas on the sides of the light emitting units 151, 152, and 153. However, during the manufacturing process, it is very difficult to form the passivation layer 157 limited to one area of the light emitting portions 151, 152, and 153. Therefore, it is very difficult to form the first electrode 154 limited to other areas on the sides of the light emitting units 151, 152, and 153.

In the embodiment, a plurality of trenches are formed in the light emitting units 151, 152, and 153, the passivation layer 157 may be easily formed limited to one area of the light emitting portions 151, 152, and 153 using a plurality of trenches, accordingly, the first electrode 154 may also be easily formed limited to other areas of the light emitting units 151, 152, and 153.

Accordingly, the plurality of trenches may serve as a stopper that allows the passivation layer 157 to be formed limited to one area on the side of the light emitting portions 151, 152, and 153.

For example, one trench among a plurality of trenches formed in the light emitting portions 151, 152, and 153, for example, the end 157a of the passivation layer 157 may be located in the first trench 1110 based on the first trench 1110. That is, the passivation layer 157 is formed on the top and sides of the light emitting portions 151, 152, and 153, and may be located in the first trench 1110 provided on the sides of the light emitting portions 151, 152, and 153. Accordingly, the passivation layer 157 may not be formed on the sides of the light emitting portions 151, 152, and 153 located below the first trench 1110. The first electrode 154 may be formed on the sides of the light emitting units 151, 152, and 153 located in the area of the first trench 1110.

Accordingly, the first trench 1110 may be a boundary area between the passivation layer 157 and the first electrode 154. That is, the end 157a of the passivation layer and the end 154a of the first electrode 154 may contact each other in the first trench 1110.

For example, a plurality of trenches may be disposed along the circumference of the sides of the light emitting units 151, 152, and 153, but is not limited to this. Therefore, the end 157a of the passivation layer 157 and the end 154a of the first electrode 154 are in contact with the first trench 1110 disposed along the circumference of the side of the light emitting portion 151, 152, and 153. That is, with respect to the first trench 1110, the passivation layer 157 is disposed along the perimeter of the sides of the light emitting units 151, 152, and 153 located above the first trench 1110, the first electrode 154 may be disposed along the circumference of the side of the light emitting units 151, 152, and 153 located below the first trench 1110.

Each of the plurality of trenches may have an asymmetric groove 1200. For example, each of the plurality of trenches may have a bottom portion 151a having a first width w1 and a side portion 151b that is in contact with the bottom portion 151a and has a second width w2 greater than the first width. Due to this asymmetric groove 1200, the end 157a of the passivation may be easily positioned in a plurality of trenches, that is, the first trench 1110.

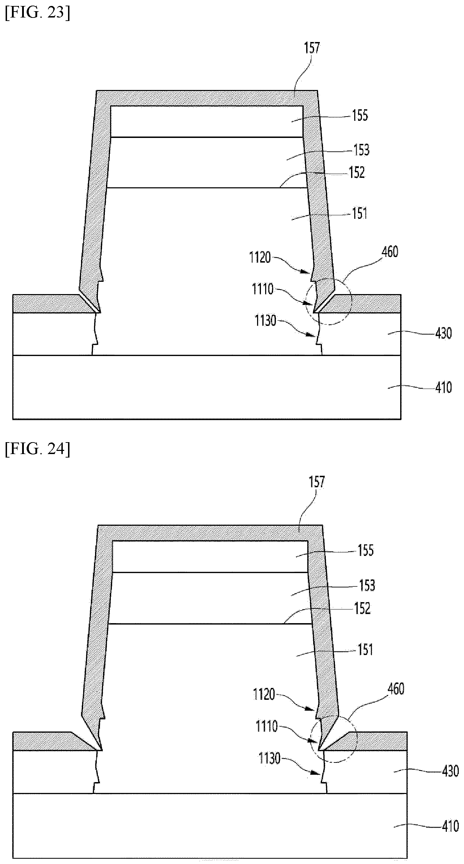

As will be explained later (see FIGS. 23 to 27), even if the passivation layer 157 is formed on the side surfaces of the light emitting units 151, 152, and 153 by the asymmetric groove 1200 of the first trench 1110, with respect to the first trench 1110, a passivation layer 157 located above the first trench 1110 and a passivation layer 157 located below the first trench 1110, that is, the passivation layers (157 in FIG. 23) formed on the photosensitive film may be spaced apart from each other. In this case, the passivation layer 157 located in the area of the first trench 1110 is removed, only the passivation layer 157 located over the first trench 1110 may be disposed on the sides of the light emitting portions 151, 152, and 153.

Meanwhile, the angle θ between the bottom portion 151a and the side portion 151b may have an acute angle, but this is not limited. The fact that the angle θ between the bottom portion 151a and the side portion 151b has an acute angle means that the depth of each of the plurality of trenches becomes deeper. As the depth of each of the plurality of trenches becomes deeper, as shown in FIGS. 23 and 24, with respect to the first trench 1110, the passivation layer 157 located above the first trench 1110 and the passivation layer 157 located below the first trench 1110 are more easily separated, the passivation layer 157 located below the first trench 1110 may be easily removed.

Meanwhile, the plurality of trenches are formed so that the passivation layer 157 is not formed on the side of the first conductivity-type semiconductor layer 151 as much as possible, the first electrode 154 is easily formed on the side of the first conductivity-type semiconductor layer 151. Accordingly, a plurality of trenches may be disposed on the side of the first conductivity-type semiconductor layer 151.

For example, the plurality of trenches may include a first trench 1110 disposed on the first area on the side of the first conductivity-type semiconductor layer 151. For example, the plurality of trenches may include at least one second trench 1120 disposed on the second area on the side of the first conductivity-type semiconductor layer 151. The second area may be located above the first area. For example, the plurality of trenches may include at least one third trench 1130 disposed on the third region on the side of the first conductivity-type semiconductor layer 151. The third area may be located below the first area.

For example, the end 157a of the passivation layer 157 may be located in the first trench 1110. For example, the end 154a of the first electrode 154 may contact the end 157a of the passivation layer 157 in the first trench 1110.

For example, the passivation layer 157 may be disposed in at least one second trench 1120. By placing the passivation layer 157 in the asymmetric groove 1200 of the second trench 1120, the contact area between the passivation layer 157 and the side of the first conductivity-type semiconductor layer 151 is increased, thereby preventing the passivation layer 157 from being separated.

For example, the first electrode 154 may be disposed in at least one third trench 1130. By placing the first electrode 154 in the asymmetric groove 1200 of the third trench 1130, the contact area between the second electrode 155 and the side of the first conductivity-type semiconductor layer 151 increases, thereby strengthening the bonding force of the first electrode 154 and preventing the first electrode 154 from being separated.

Meanwhile, as shown in FIG. 13, light generated in the active layer 152 is reflected or scattered by a plurality of trenches to extract more light, so light extraction efficiency may be improved and luminance may be improved.

Meanwhile, referring again to FIGS. 11 and 12, the connection electrode 350 may be in contact with the first electrode 154 of the semiconductor light emitting device 150. That is, the connection electrode 350 may be in contact with the first electrode 154 to be disposed on the side of the semiconductor light emitting device 150. For example, the connection electrode 350 may be disposed on a side of the first conductivity type semiconductor light emitting device 150 of the semiconductor light emitting device 150. In addition, the connection electrode 350 may be connected to at least one of the first assembly wiring 321 and the second assembly wiring 322. Accordingly, the lead electrode may connect the first electrode 154 of the semiconductor light emitting device 150 to at least one of the first assembly wiring 321 and the second assembly wiring 322.

The connection electrode 350 is in contact with the passivation layer 157 of the semiconductor light emitting device 150 and the inner side of the assembly hole 345 within the assembly hole 345, by strengthening the adhesion of the connection electrode 350, separation of the connection electrode 350 may be prevented.

Since the thickness of the passivation layer 157 is relatively thin, to prevent an electrical short from occurring between the connection electrode 350 and the active layer 152 through the passivation layer 157, the upper side of the connection electrode 350 may be positioned at least lower than the active layer 152 and disposed on the side of the first conductivity-type semiconductor layer 151.

For example, the upper side of the connection electrode 350 disposed on the inner side of the assembly hole 345 and the upper side of the connection electrode 350 disposed on the side of the semiconductor light emitting device 150 may be at the same position (or height), but is not limited to this.

Meanwhile, the electrode wiring 372 may be connected to the second electrode 155 of the semiconductor light emitting device 150. At least one assembly wiring of the first assembly wiring 321 and the second assembly wiring 322 is called the first electrode 154 wiring, the electrode wiring 372 may be referred to as the second electrode wiring 155. In this case, current flows to the semiconductor light emitting device 150 through at least one of the first assembly wiring 321 and the second assembly wiring 322 and the assembly wiring 372, and the semiconductor light emitting device 150 may emit light with luminance corresponding to the corresponding current.

The display device 300 according to the first embodiment may include a second insulating layer 360.

The second insulating layer 360 may be formed of an organic material or an inorganic material. For example, the second insulating layer 360 may be disposed on the semiconductor light emitting device 150 and the partition wall 340. The second insulating layer 360 may be disposed in the assembly hole 345. For example, the second insulating layer 360 may be disposed in the groove formed by the connection electrode 350 within the assembly hole 345.

For example, a portion of the second insulating layer 360 may be removed to form a contact hole exposing the second electrode 155 of the semiconductor light emitting device 150. The electrode wiring 372 may be electrically connected to the second electrode 155 of the semiconductor light emitting device 150 through this contact hole.

Meanwhile, the unexplained symbol 333 is an adhesive layer, which allows the semiconductor light emitting device 150 to be attached to the first insulating layer 330 in the assembly hole 345.

Below, the manufacturing process of the semiconductor light emitting device 150 according to the first embodiment will be described with reference to FIGS. 16 to 29.

FIGS. 16 to 29 show the manufacturing process of a semiconductor light emitting device according to the first embodiment.

As shown in FIG. 16, the first conductivity-type semiconductor layer 151, the active layer 152, and the second conductivity-type semiconductor layer 153 may be grown on the wafer 401 using deposition equipment such as MOCVD.

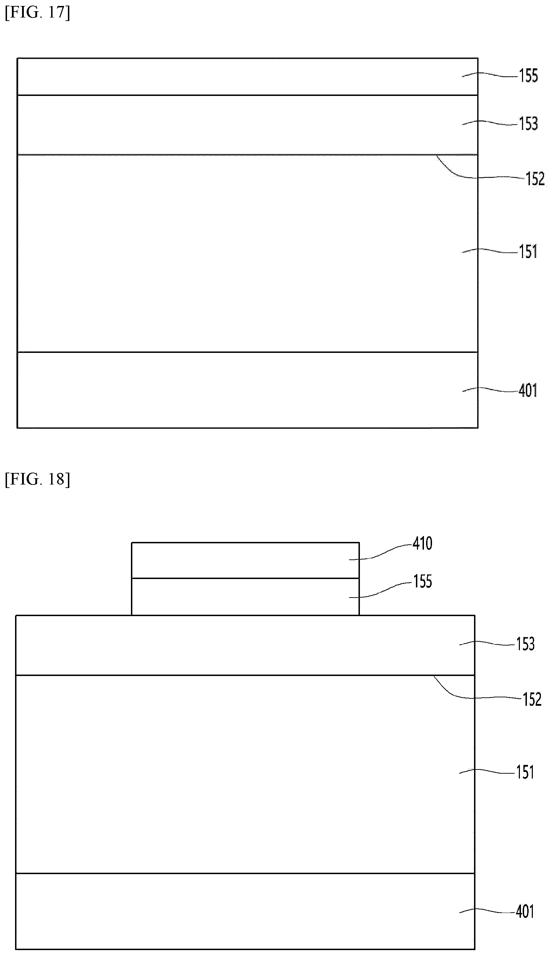

As shown in FIG. 17, the second electrode 155 may be formed on the second conductivity-type semiconductor layer 153 using a deposition process. In the drawing, the second electrode 155 is formed limited to a portion of the upper surface of the second conductivity-type semiconductor layer 153, but this is not limited.

As shown in FIG. 18, a mask layer 410 may be formed on the upper electrode. The mask layer 410 may be made of, for example, silicon dioxide (SiO2), but is not limited thereto.

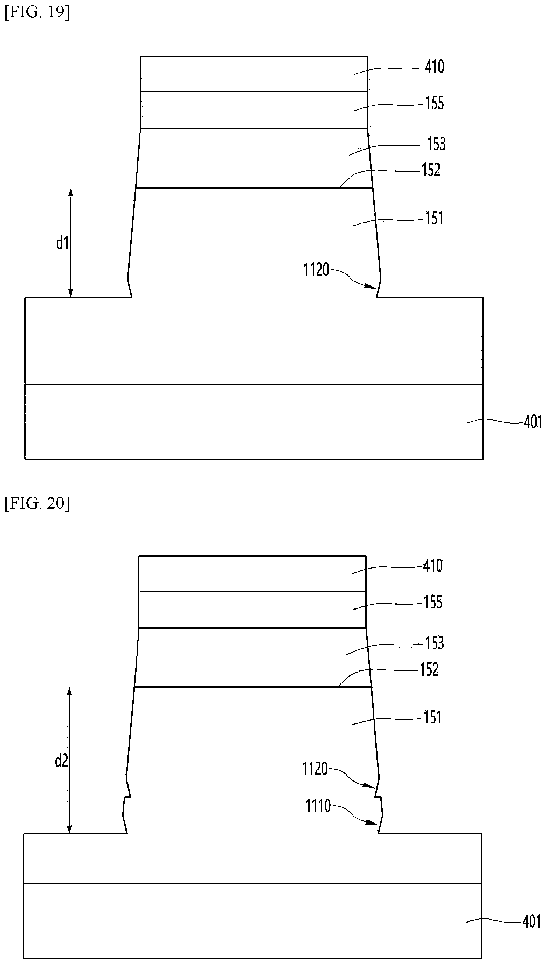

As shown in FIG. 19, a first etching process is performed using the mask layer 410 as a mask to remove the second conductivity-type semiconductor layer 153 and the active layer 152 along the vertical direction, subsequently, after the first conductive semiconductor is removed from the upper surface to a first depth d1, the first etching process may be stopped. In this case, the second trench 1120 may be formed in an area where the top and side surfaces of the first conductivity-type semiconductor layer 151 removed to the first depth d1 meet.

As shown in FIG. 20, a secondary etching process may be performed using the mask layer 410 as a mask, and the secondary etching process may be stopped after the upper surface of the first conductivity-type semiconductor layer 151 is removed to a second depth d2. In this case, the first trench 1110 may be formed in an area where the top and side surfaces of the first conductivity-type semiconductor layer 151 removed to the second depth d2 meet.

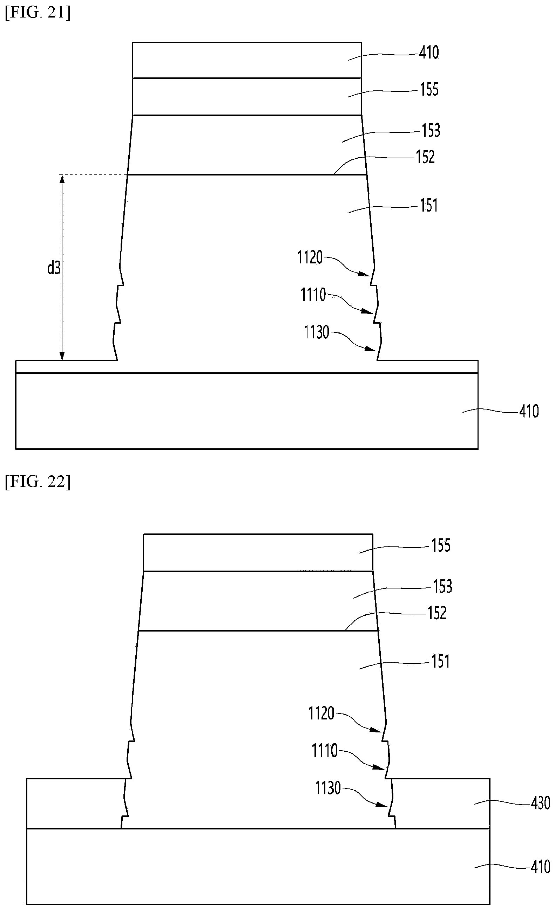

As shown in FIG. 21, a third etching process may be performed using the mask layer 410 as a mask, and the third etching process may be stopped after the upper surface of the first conductivity-type semiconductor layer 151 is removed to a third depth d3. In this case, the third trench 1130 may be formed in an area where the top and side surfaces of the first conductivity-type semiconductor layer 151 removed to the third depth d3 meet.

Afterwards, a fourth etching process is performed using the mask layer 410 as a mask, and the first conductivity-type semiconductor layer 151 may be removed to expose the upper surface of the wafer.

As shown in FIG. 22, a photosensitive film 430 may be formed on the exposed wafer. The top surface of the photosensitive film 430 may be located in the first trench 1110. The photoresist film may prevent the passivation layer 157, which will be described later, from being formed on the side of the first conductivity-type semiconductor layer 151 located in the area of the first trench 1110.

As shown in FIG. 23, the passivation layer 157 may be formed on the entire area of the substrate 310. For example, the passivation layer 157 may be formed on the photosensitive film. For example, the passivation layer 157 may be formed on the mask layer 410. For example, the passivation layer 157 may be formed on the side of the mask layer 410, the side of the second conductivity-type semiconductor layer 153, and the side of the active layer 152. For example, the passivation layer 157 may be formed on the side of the first conductivity-type semiconductor layer 151 located above the first trench 1110.

Meanwhile, since the first trench 1110 has an asymmetric groove 1200, the passivation layer 157 may not be formed in the first trench 1110.
in other words, the passivation layer 157 formed on the side of the first conductivity-type semiconductor layer 151 located on the first trench 1110 with respect to the first trench 1110 and the passivation layer 157 formed on the photosensitive film may be spaced apart from each other. This may be due to differences in growth of the passivation layer 157. For example, the growth of the passivation layer 157 on the side of the first conductivity-type semiconductor layer 151 and the top surface of the photosensitive film is different. Because of this growth difference, the passivation layer 157 formed on the side of the first conductivity-type semiconductor layer 151 located on the first trench 1110 with respect to the first trench 1110 and the passivation layer 157 formed on the photosensitive film may be spaced apart from each other.

As shown in FIG. 24, the surface of the passivation layer 157 is removed using a wet etching process, the passivation layer 157 formed on the side of the first conductivity-type semiconductor layer 151 located on the first trench 1110 and the passivation layer 157 formed on the photosensitive film may be spaced further apart, forming a larger gap.

If the separation distance between the passivation layer 157 formed on the side of the first conductivity-type semiconductor layer 151 located on the first trench 1110 and the passivation layer 157 formed on the photosensitive film is sufficient, the wet etching process may be omitted.

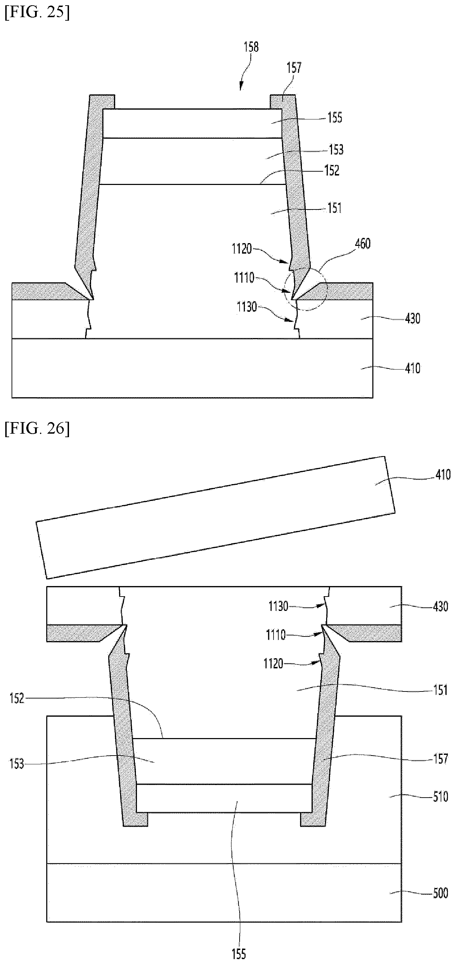

As shown in FIG. 25, by performing an additional wet process, the passivation layer 157 on the second electrode 155 may be removed to form an opening 158 on the second electrode 155.

As shown in FIG. 26, the wafer may be turned over and transferred onto the transfer substrate 500. That is, the wafer is turned over so that the second electrode 155 faces the transfer substrate 500, and then the wafer is pressed so that a partial region of the semiconductor light emitting device 150 is buried in the adhesive layer 510. In other words, the semiconductor light emitting device 150 may be attached to the transfer substrate 500 through the adhesive layer 510.

Next, the wafer may be separated by performing a LLO (Lase Lift-Off) process using a laser.

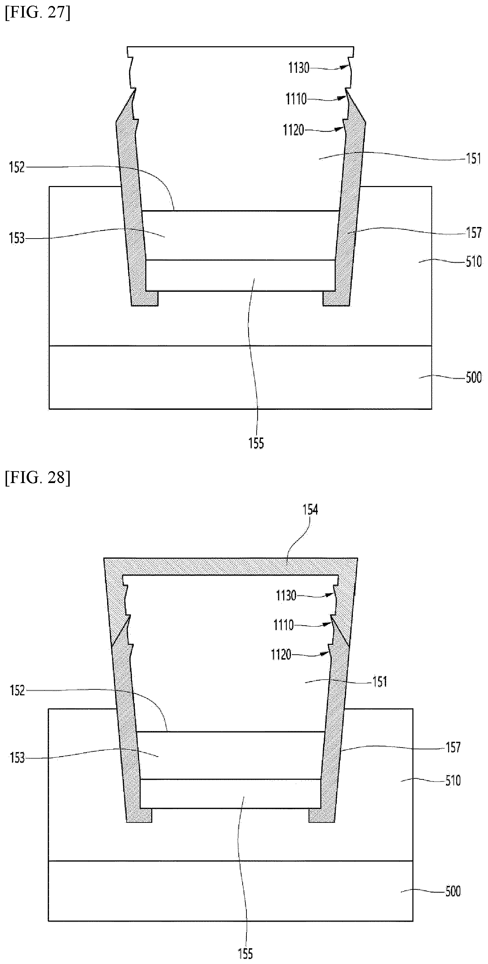

Therefore, as shown in FIG. 27, the photoresist film is separated by performing a PLO (PR Lift-Off) process, so that the passivation layer 157 on the photoresist film may be removed. The PLO process may be performed using an etchant that may etch the photosensitive film. In this case, the lower surface (based on before turning over the semiconductor light emitting device 150) and a portion of the side portion of the first conductivity-type semiconductor layer 151 with respect to the first trench 1110 may be exposed to the outside.

As shown in FIG. 28, after the first electrode 154 is formed, a pattern process may be performed to form the first electrode 154 on a portion of the lower surface and sides of the first conductivity-type semiconductor layer 151.

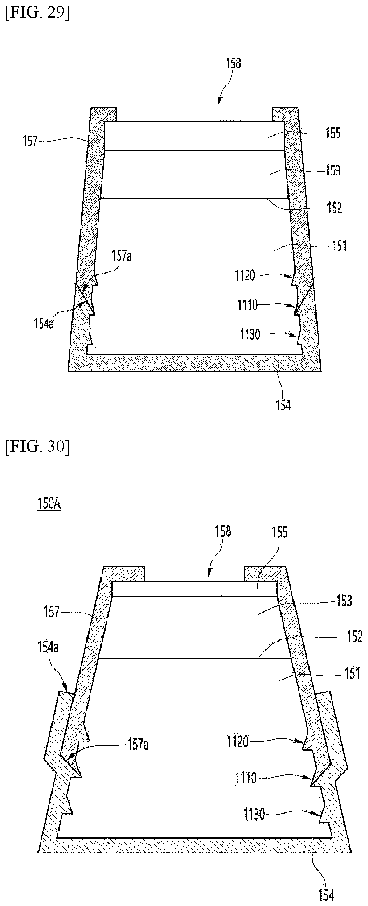

As shown in FIG. 29, the adhesive layer is removed and the transfer substrate 500 is separated, so that the semiconductor light emitting device 150 may be manufactured. For example, by immersing the transfer substrate 500 shown in FIG. 28 in a container containing an etchant, the adhesive layer may be removed by the etchant. By removing the adhesive layer, the transfer substrate 500 may be separated from the semiconductor light emitting device 150. Thereafter, the semiconductor light emitting device 150 included in the container may be recovered using a recovery process.

Although not shown, a cleaning process may be performed to remove residues from the etchant attached to the recovered semiconductor light emitting device 150.

### [Second embodiment]

FIG. 30 is a cross-sectional view showing a semiconductor light emitting device according to the second embodiment.

The second embodiment is the same as the first embodiment except for the placement position of the first electrode 154. In the second embodiment, components having the same shape, structure, and/or function as those of the first embodiment are assigned the same reference numerals and detailed descriptions are omitted.

Referring to FIG. 30, the semiconductor light emitting device 150A according to the second embodiment may include light emitting units 151, 152, and 153, a first electrode 154, a second electrode 155, trenches 1110, 1120, and 1130, and a passivation layer 157. The semiconductor light emitting device 150A according to the second embodiment may include more components.

The light emitting unit may include a first conductivity-type semiconductor layer 151, an active layer 152, and a second conductivity-type semiconductor layer 153.

A plurality of trenches may be disposed on the sides of the light emitting unit. For example, a plurality of trenches may be disposed on the side of the first conductivity-type semiconductor layer 151.

The plurality of trenches includes a first trench 1110, at least one second trench 1120 located above the first trench 1110, and one or more third trenches 1130 located below the first trench 1110.

For example, the passivation layer 157 may be disposed on the top of the second electrode 155 and the side of the light emitting unit. For example, the passivation layer 157 may be disposed in the second trench 1120. For example, the end 157a of the passivation layer 157 may be located in the first trench 1110.

For example, the first electrode 154 may be disposed on the lower portion and side of the first conductivity-type semiconductor layer 151.

For example, the first electrode 154 may be disposed in the third trench 1130. For example, the first electrode 154 may be disposed in the first trench 1110. For example, the first electrode 154 may be disposed on the passivation layer 157. In other words, the first electrode 154 may extend from the bottom of the first conductivity-type semiconductor layer to the passivation layer 157 via the third trench 1130 and the first trench 1110 disposed on the side of the first conductivity-type semiconductor layer 151.

Therefore, by arranging the first electrode 154 over a larger area on the side of the light emitting unit, the contact area between the connection electrode 350 and the semiconductor light emitting device 150A may be maximized to obtain maximum brightness.

In addition, the first electrode 154 is disposed not only on the first conductivity-type semiconductor layer 151 but also on the passivation layer 157, the bonding force of the first electrode 154 may be strengthened and separation of the first electrode 154 may be prevented.

The above detailed description should not be construed as restrictive in any respect and should be considered illustrative. The scope of the embodiments should be determined by reasonable interpretation of the appended claims, and all changes within the equivalent scope of the embodiments are included in the scope of the embodiments.

### [Industrial applicability]

The embodiment may be adopted in the field of displays that display images or information.

The embodiment may be adopted in the field of displays that display images or information using semiconductor light emitting devices. The semiconductor light emitting device may be a micro-level semiconductor light emitting device or a nano-level semiconductor light emitting device.

## Claims

1. A semiconductor light emitting device comprising:
a light emitting unit;
a first electrode on a bottom and a side of the light emitting unit;
a second electrode on a top of the light emitting unit;
a plurality of trenches on the side of the light emitting unit; and
a passivation layer on the side of the light emitting unit,
wherein an end of the passivation layer is disposed in one of the plurality of trenches.

2. The semiconductor light emitting device according to claim 1, wherein the plurality of trenches are disposed along a circumference of the side of the light emitting unit.

3. The semiconductor light emitting device according to claim 1, wherein an end of the first electrode is disposed in the one trench.

4. The semiconductor light emitting device according to claim 3, wherein the end of the first electrode is configured to contact an end of the passivation layer in the one trench.

5. The semiconductor light emitting device according to claim 1, wherein an end of the first electrode is disposed on the passivation layer.

6. The semiconductor light emitting device according to claim 1, wherein each of the plurality of trenches comprises an asymmetric groove.

7. The semiconductor light emitting device according to claim 6, wherein each of the plurality of trenches comprises a bottom portion comprising a first width and a side portion to be in contact with the bottom portion and comprising a second width greater than the first width.

8. The semiconductor light emitting device according to claim 7, wherein an angle between the bottom portion and the side portion has an acute angle.

9. The semiconductor light emitting device according to claim 1, wherein the light emitting unit comprises a first conductivity-type semiconductor layer, an active layer on the first conductivity-type semiconductor layer, and a second conductivity-type semiconductor layer on the active layer,
wherein the plurality of trenches are disposed on a side of the first conductivity-type semiconductor layer.

10. The semiconductor light emitting device according to claim 9, wherein the plurality of trenches comprise a first trench on a first area of the side of the first conductivity-type semiconductor layer and at least one second trench on a second area of the side of the first conductivity-type semiconductor layer

11. The semiconductor light emitting device according to claim 10, wherein the end of the passivation layer is disposed in the first trench.

12. The semiconductor light emitting device according to claim 11, wherein the end of the first electrode is configured to contact the end of the passivation in the first trench.

13. The semiconductor light emitting device according to claim 10, wherein the passivation layer is disposed in the at least one second trench.

14. The semiconductor light emitting device according to claim 10, wherein the plurality of trenches comprises at least one third trench on the third region of the side of the first conductivity-type semiconductor layer, and
wherein the first electrode is disposed in the at least one third trench.

15. The semiconductor light emitting device according to claim 1, wherein the first electrode comprises a reflective layer.

16. A display device comprising:
a substrate;
a first assembly wiring and a second assembly wiring on the substrate;
a partition wall disposed on the first assembly wiring and the second assembly wiring and having an assembly hole;
a semiconductor light emitting device in the assembly hole; and
a connection electrode is disposed in the assembly hole and connects the semiconductor light emitting device to at least one of the first and second assembly wirings,
wherein the semiconductor light emitting device comprises a light emitting unit, a first electrode on a bottom and a side of the light emitting unit, a second electrode on a top of the light emitting unit, a plurality of trenches on the sides of the light emitting unit, and a passivation layer on the side of the light emitting unit, and
wherein the end of the passivation layer is disposed in one of the plurality of trenches.

17. The display device according to claim 16, wherein the connection electrode is configured to contact the first electrode of the semiconductor light emitting device.

18. The display device according to claim 17, wherein the connection electrode is configured to contact the passivation layer of the semiconductor light emitting device and an inner surface of the assembly hole within the assembly hole.

19. The display device according to claim 16, wherein the connection electrode is disposed along a circumference of the semiconductor light emitting device within the assembly hole.

20. The display device according to claim 16, further comprising an insulating layer on the partition wall and an electrode wiring connected to the semiconductor light emitting device through the insulating layer.
